# EUROPEAN PATENT SPECIFICATION

(11) **EP 2 212 920 B1**
(45) Date of publication and mention of the grant of the patent: **15.06.2016**
(21) Application number: 09803161.0
(22) Date of filing: 30.07.2009
(51) Int. Cl.: H01L 31/042, H01L 31/0224

(54) **SOLAR CELL, METHOD OF MANUFACTURING THE SAME, AND SOLAR CELL MODULE**
SOLARZELLE, VERFAHREN ZU IHRER HERSTELLUNG UND SOLARZELLENMODUL
CELLULE SOLAIRE, PROCÉDÉ DE FABRICATION ASSOCIÉ ET MODULE DE CELLULE SOLAIRE

(30) Priority: 01.08.2008 KR 20080075781
(43) Date of publication of application: 04.08.2010
(73) Proprietor: LG Electronics Inc., Seoul 150-721 (KR)
(72) Inventor: KIM, Jonghwan, Seoul 137-130 (KR); KO, Jihoon, Seoul 137-130 (KR); YUN, Juhwan, Seoul 137-130 (KR)
(74) Representative: Katérle, Axel
(86) International application number: PCT/KR2009/004253
(87) International publication number: WO 2010/013956

(56) References cited:
- WO-A1-2008/078741
- WO-A2-2008/068336
- JP-A- 2008 034 609
- KR-A- 20070 099 938
- KR-B1- 100 682 017
- US-A- 6 143 976
- US-A1- 2005 176 164
- US-A1- 2006 001 147
- US-A1- 2006 060 238
- US-B1- 6 384 317

## Description

### Technical Field

Embodiments relate to a solar cell, a method of manufacturing the same, and a solar cell module.

### Background Art

A solar cell is an element capable of converting light into electricity. The solar cell may be mainly classified into a silicon-based solar cell, a compound-based solar cell, and an organic-based solar cell depending on a material used. The silicon-based solar cell may be classified into a crystalline silicon (c-Si) solar cell and an amorphous silicon (a-Si) solar cell depending on a phase of a semiconductor. Further, the solar cell may be classified into a bulk type solar cell and a thin film type solar cell depending on a thickness of a semiconductor. The c-Si solar cell may be the bulk type solar cell, and the a-Si solar cell may be the thin film type solar cell.

A general operation of the solar cell is as follows. If light coming from the outside is incident on the solar cell, electron-hole pairs are formed inside a semiconductor of the solar cell. Electrons move to an n-type semiconductor and holes move to a p-type semiconductor by an electric field generated in a p-n junction of the electron-hole pairs to thereby produce electric power.

A related art solar cell has a problem of low efficiency.

US 6,384,317 B1 discloses a method for manufacturing a solar cell with a first electrode and a second electrode. The solar cell comprises an emitter region. In one variant, the emitter region is of the selective-type.

US 2009/272419 A1 and WO 2008/078741 A1 disclose a method to manufacture a solar cell with a first surface and a second surface. The solar cell comprises a semiconductor substrate with a through hole. The through hole houses a first electrode which presents a main electrode part, a conductive part and a first connection part. A second electrode is placed on the second surface.

US 2005/176164 A1 discloses a method for manufacturing a solar cell with grid contacts. One grid contact is in contact with a heavily doped phosphorous diffusion layer. The surfaces of the substrate are covered by light phosphorous diffusion layers.

### Disclosure of Invention

### Brief Description of Drawings

FIGS. 1 to 3 illustrate a structure of a solar cell according to an embodiment;
FIGS. 4 to 6 illustrate a method of manufacturing a solar cell according to an embodiment;
FIGS. 7 to 11 illustrate in detail a first electrode;
FIGS. 12 and 13 are diagrams for comparing a solar cell of a comparative example with a solar cell according to an embodiment;
FIG. 14 illustrates an example of a structure of a through hole;
FIGS. 15 and 16 illustrate another structure of a solar cell according to an embodiment;
FIGS. 17 and 18 illustrate a solar cell module according to an embodiment; and
FIGS. 19 and 20 illustrate another method of manufacturing a solar cell according to an embodiment.

### Mode for the Invention

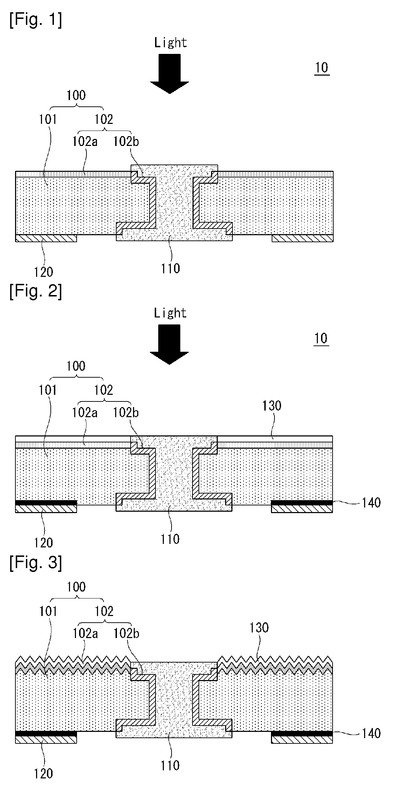

FIGS. 1 to 3 illustrate a structure of a solar cell according to an embodiment.

As shown in FIG. 1, a solar cell 10 according to an embodiment includes a semiconductor part 100, a first electrode 110, and a second electrode 120.

In FIG. 1, the lower portion of the solar cell 10 depicts the second electrode 120 as being rotated 90 to more easily show the location of the second electrode relative to the first electrode. Subsequent figures also take advantage of the rotated depiction of the second electrode.

The semiconductor part 100 includes a semiconductor substrate 101 doped with first impurities and an emitter layer 102. The emitter layer 102 includes a first portion 102a, that is positioned on one surface of the semiconductor substrate 101 and is doped with second impurities of a conductive type different from a conductive type of the first impurities at a first doping concentration, and a second portion 102b doped with the second impurities at a second doping concentration greater than the first doping concentration. One of the first impurities and the second impurities may be n-type impurities, and the other may be p-type impurities. The first impurities may be first conductive type impurities, and the second impurities may be second conductive type impurities different from the first conductive type impurities.

The first electrode 110 may be formed to pass from the one surface to the other surface of the semiconductor substrate 101.

The second electrode 120 is positioned on the other surface of the semiconductor substrate 101 and may be electrically separated from the first electrode 110. The second electrode 120 on the other surface (a rear surface) of the semiconductor substrate 101 may be referred to as a rear electrode.

The one surface of the semiconductor substrate 101 is a light receiving surface on which light from the outside is incident, and the other surface of the semiconductor substrate 101 may be opposite to the one surface of the semiconductor substrate 101.

The semiconductor substrate 101 and the emitter layer 102 may form a p-n junction. For example, the semiconductor substrate 101 may be a p-type semiconductor, and the emitter layer 102 may be an n-type semiconductor.

If light from the outside is incident on the semiconductor substrate 101, light energy is converted into electrical energy in a p-n junction surface between the semiconductor substrate 101 and the emitter layer 102, and thus, electric power may be produced. More specifically, if light from the outside is incident on the semiconductor substrate 101, electrons produced in the p-n junction surface between the semiconductor substrate 101 and the emitter layer 102 move to the first electrode 110, and holes produced in the p-n junction surface move to the second electrode 120. Hence, a current flows in the solar cell 10.

As above, the emitter layer 102 may include the first portion 102a and the second portion 102b each having a different doping concentration. The first portion 102a is a lightly doped region doped with the second impurities at the first doping concentration, and the second portion 102b is a heavily doped region doped with the second impurities at the second doping concentration greater than the first doping concentration.

A doping depth of the second impurities in the second portion 102b is greater than a doping depth of the second impurities in the first portion 102a. Further, a surface doping concentration of the second portion 102b may be greater than a surface doping concentration of the first portion 102a.

The second impurities may be impurities for forming the n-type semiconductor, and preferably, may be phosphor (P), though not required.

Preferably, the second portion 102b may be an n⁺⁺-type doping region, and the first portion 102a may be an n-type doping region, though not required. Alternatively, the first portion 102a may be an n⁺-type doping region, for example.

The second portion 102b contacts the first electrode 110 passing through the two surfaces of the semiconductor substrate 101.

As described above, a structure in which a lightly doped region and a heavily doped region are formed on the semiconductor substrate 101 and an electrode is formed in the heavily doped region may be referred to as a selective emitter structure.

A through hole (not shown) passing from the one surface to the other surface of the semiconductor substrate 101 is formed, a portion of the first electrode 110 or the entire first electrode 110 is positioned in the through hole, and the first electrode 110 contacts the second portion 102b (i.e., the heavily doped region) in the through hole. In addition, the first electrode 110 need not contact the first portion 102a (i.e., the lightly doped region).

In the embodiment, the contact between the first electrode 110 and the second portion 102b may indicate that the first electrode 110 overlaps the second portion 102b. Alternatively, the contact between the first electrode 110 and the second portion 102b may indicate that the first electrode 110 is formed on the second portion 102b.

As the first electrode 110 contacts the second portion 102b, a contact resistance between the first electrode 110 and the second portion 102b is reduced, and thus, an efficiency of the solar cell may be improved. Namely, the efficiency of the solar cell is improved by reducing a resistance of the solar cell 10.

Further, impurities are reduced or prevented from excessively remaining inside the semiconductor part 100 by forming the first portion 102a as the lightly doped region. Hence, a reduction in life span of the solar cell is suppressed.

As the first electrode 110 is formed to pass through the two surfaces of the semiconductor substrate 101, a size of the light receiving surface of the semiconductor substrate 101 covered by the first electrode 110 are reduced. Hence, the efficiency of the solar cell is further improved. Namely, a shadow loss effect of the solar cell is reduced.

Although FIG. 1 illustrates that the semiconductor substrate 101 is the p-type semiconductor and the emitter layer 102 is the n-type semiconductor, the semiconductor part 100 may further include an intrinsic-type (i-type) semiconductor. Further, the semiconductor part 100 may include a plurality of p-type semiconductors or a plurality of n-type semiconductors. In addition, the semiconductor substrate 101 may be the n-type semiconductor, and the emitter layer 102 may be the p-type semiconductor.

The structure of the semiconductor part 100 is not particularly limited as long as the semiconductor part 100 includes the lightly doped region and the heavily doped region. For example, the semiconductor part 100 may include one of c-Si silicon and a-Si silicon or may include both c-Si silicon and a-Si silicon under condition that the semiconductor part 100 includes the lightly doped region and the heavily doped region.

As shown in FIG. 2, the solar cell 10 may further include an anti-reflection layer 130 on the one surface of the semiconductor substrate 101. The anti-reflection layer 130 reduces or prevents light from the outside from being reflected on the semiconductor substrate 101 to thereby reduce a light reflectance of the solar cell 10. Hence, the efficiency of the solar cell 10 can be improved. The anti-reflection layer 130 may have a single-layered structure or a multi-layered structure.

The solar cell 10 may further include a back surface field (BSF) layer 140 between the second electrode 120 and the semiconductor substrate 101. The BSF layer 140 is a p+-type region and reduces a transfer resistance of carriers. Hence, the efficiency of the solar cell 10 can be improved.

As shown in FIG. 3, an uneven pattern may be formed on the semiconductor substrate 101. In this case, because the size of the light receiving surface of the semiconductor substrate 101 increases, the efficiency of the solar cell 10 can be improved.

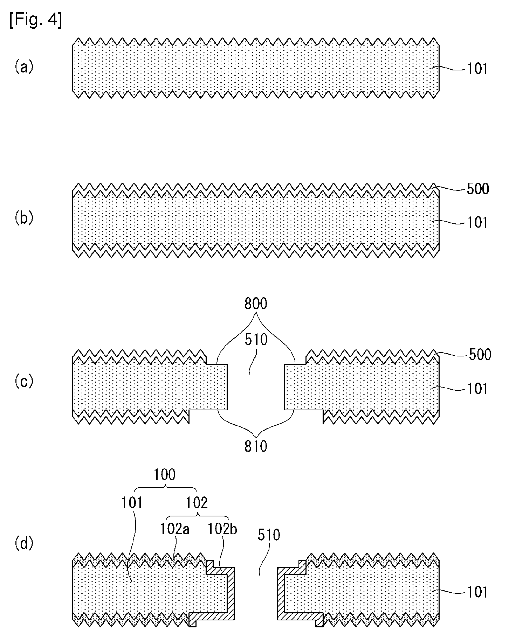

FIGS. 4 to 6 illustrate a method of manufacturing a solar cell according to an embodiment.

As shown in (a) of FIG. 4, an uneven pattern may be formed on the surface of the semiconductor substrate 101.

Next, as shown in (b) of FIG. 4, a diffusion barrier layer 500 may be formed on the surface of the semiconductor substrate 101 having the uneven pattern. The diffusion barrier layer 500 may be formed of at least one of silicon oxide (Si0₂) silicon nitride (SiNx), amorphous silicon, and nanoporous silicon. The diffusion barrier layer 500 prevents penetration of impurities to thereby contribute to a formation of the lightly doped region.

Namely, the diffusion barrier layer 500 is formed at a formation location of the lightly doped region to be formed in a subsequent process. A thickness of the diffusion barrier layer 500 may be several nanometers to several dozens of nanometers.

Next, as shown in (c) of FIG. 4, the through hole 510 may be formed in the semiconductor substrate 101. Preferably, though not required, the through hole 510 may be formed in the semiconductor part 100 using a laser.

In a process illustrated in (c) of FIG. 4, when the through hole 510 is formed in the semiconductor part 100, a pattern of a heavily doped region may be formed together. For example, in the process illustrated in (c) of FIG. 4, when the through hole 510 is formed in the semiconductor part 100, a space where a finger electrode and a bus bar electrode of a first electrode will be positioned may be together provided by simultaneously etching a portion of each of the one surface and the other surface of the semiconductor part 100. Hence, a first region 800 whose height is less than a height of a peripheral portion may be formed at an edge of the through hole 510 on the one surface of the semiconductor part 100, and a second region 810 whose height is less than a height of a peripheral portion may be formed at the edge of the through hole 510 on the other surface of the semiconductor part 100. The finger electrode of the first electrode may be positioned in the first region 800, and the bus bar electrode of the first electrode may be positioned in the second region 810. It may be preferable, but not required, that a width of the first region 800 is less than a width of the second region 810 so as to increase the size of the light receiving surface of the semiconductor part 100.

As above, in a process for forming the through hole 510 in the semiconductor part 100, a portion of the diffusion barrier layer 500 may be removed by irradiating a laser beam onto the portion of the diffusion barrier layer 500. In addition, a portion of the diffusion barrier layer 500, onto which the laser beam is not irradiated, may remain on the surface of the semiconductor part 100.

After forming the through hole 510 in the semiconductor part 100, a process for removing a portion of the semiconductor part 100 damaged by the etching process may be added. For example, after forming the through hole 510 in the semiconductor part 100 using the laser, a damage layer produced on the surface of the semiconductor part 100 because of the laser may be removed using a basic solution such as KOH, NaOH, and tetramethylammonium hydroxide (TMAH).

Next, as shown in (d) of FIG. 4, the semiconductor substrate 101 may be doped with impurities. For example, when the semiconductor substrate 101 is a p-type semiconductor, POCl₃ of n-type impurities may be diffused on the surface of the semiconductor substrate 101 to form an n-type emitter layer 102 on the semiconductor substrate 101.

In the forming process of the through hole 510, an amount of penetrating impurities and a penetrating depth of the impurities are relatively large in a portion where the diffusion barrier layer 500 has been removed. Hence, a heavily doped region is formed. On the other hand, an amount of penetrating impurities and a penetrating depth of the impurities are not relatively large in a portion where the diffusion barrier layer 500 remains. Hence, a lightly doped region is formed. Accordingly, the emitter layer 102 including the heavily doped region and the lightly doped region may be formed on the semiconductor substrate 101.

Further, the second portion 102b corresponding to the heavily doped region may be formed inside the through hole 510 formed in the semiconductor substrate 101 by going through the above-described processes.

Further, if an etching pattern of the semiconductor substrate 101 is adjusted in the forming process of the through hole 510, the second portion 102b may be formed in a portion of each of both surfaces of the semiconductor substrate 101. Namely, the heavily doped region may be formed in the first region 800 and the second region 810 of the semiconductor substrate 101.

A gas diffusion method may be used so as to effectively dope impurities inside the through hole 510 in an impurity doping process. For example, the emitter layer 102 may be formed by diffusing POCl₃ gas of n-type impurities on the surface of the semiconductor substrate 101.

A process for removing phosphosilicate glass (PSG) produced according to a doping of impurities may be added subsequent to the impurity doping process.

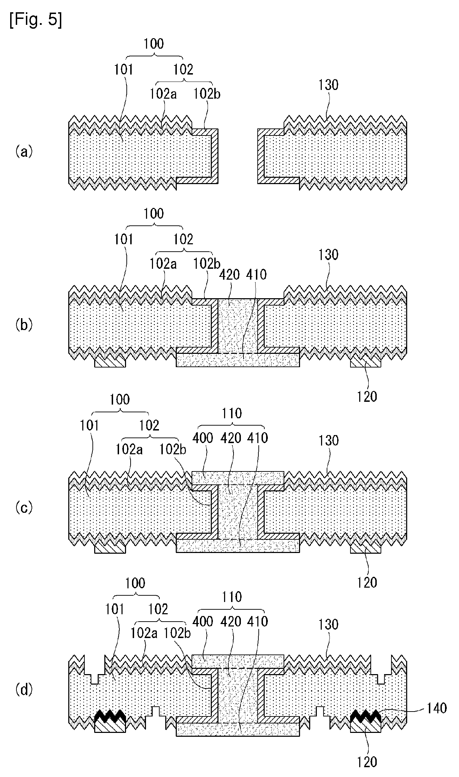

Next, as shown in (a) of FIG. 5, the anti-reflection layer 130 may be formed on one surface of the semiconductor substrate 101. The anti-reflection layer 130 may be formed of silicon oxynitride (SiOxNy), for example.

Next, as shown in (b) of FIG. 5, a bus bar electrode 410 and a connection electrode 420 of the first electrode 110 are formed in the through hole 510, and then a rear electrode, i.e., the second electrode 120 may be formed on a rear surface of the semiconductor substrate 101. The first electrode 110 may be formed of silver (Ag), and the second electrode 120 may be formed of aluminum (Al). The bus bar electrode 410, the connection electrode 420, and the second electrode 120 may be formed using a screen printing method.

Next, as shown in (c) of FIG. 5, a finger electrode 400 of the first electrode 110 may be formed on the connection electrode 420. The second portion 102b corresponding to the heavily doped region contacts the first electrode 110 by going through the processes illustrated in (b) and (c) of FIG. 5.

Next, as shown in (d) of FIG. 5, a thermal process is performed on the first electrode 110 and the second electrode 120, and thus, the first and second electrodes 110 and 120 may be electrically connected to the semiconductor part 100 and an edge isolation process to electrically separate the first and second electrodes 110 and 120 may be performed in a subsequent process. Further, the BSF layer 140 may be formed between the second electrode 120 and the semiconductor part 100, preferably, though not required, between the second electrode 120 and the semiconductor substrate 101 through the thermal process. In other words, the BSF layer 140 may be formed on the rear surface of the semiconductor substrate 101 by performing the thermal process on the second electrode 120.

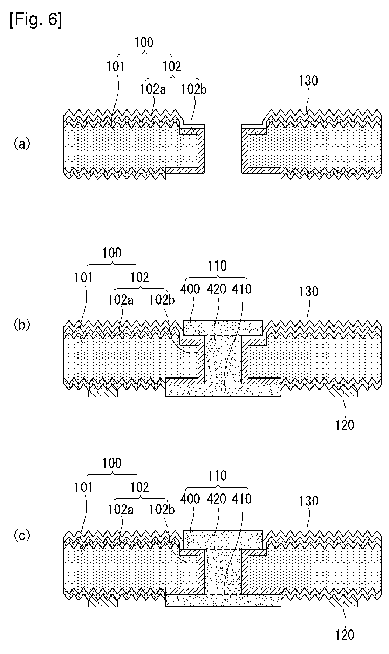

The process for forming the anti-reflection layer 130 as a diffusion barrier layer 130 and the first electrode 110 is described in detail with reference to FIG. 6.

As shown in (a) of FIG. 6, the diffusion barrier layer 130 may be formed in a portion of the second portion 102b corresponding to the heavily doped region. More specifically, the anti-reflection layer 130 may be formed at a formation location of the finger electrode 400 in the second portion 102b.

Accordingly, as shown in (b) of FIG. 6, an electrode material for forming the finger electrode 400 may be coated on a portion of the diffusion barrier layer 130. The electrode material for forming the finger electrode 400 may include a frit glass capable of improving a level of processing as well as a metal such as Ag.

Next, as shown in (c) of FIG. 6, a thermal process is performed on the electrode material to melt the frit glass and the metal. Thus, the molten frit glass and the molten metal penetrate into the diffusion barrier layer 130. As a result, a portion of the finger electrode 400 passes through the diffusion barrier layer 130 and is electrically connected to the second portion 102b.

As above, although the diffusion barrier layer 130 is formed in the heavily doped region, the finger electrode 400 may be electrically connected to the heavily doped region.

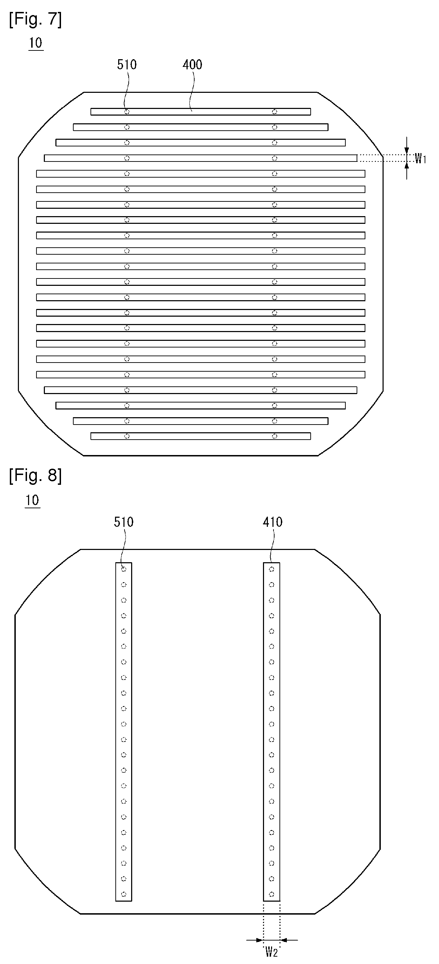

FIGS. 7 to 11 illustrate in detail the first electrode.

As shown in FIG. 7, the solar cell 10 according to an embodiment may include a first electrode line portion 400 of the first electrode on one surface (i.e., the light receiving surface) of the semiconductor substrate. The first electrode line portion 400 may be the finger electrode of the first electrode 110, and may be formed in the line form.

In other words, the first electrode line portion 400 may include the plurality of finger electrodes.

Further, the plurality of first electrode line portions 400 may be independently positioned on the one surface of the semiconductor substrate. Namely, the plurality of first electrode line portions 400 need not be connected to one another and may be positioned to be spaced apart from one another.

As shown in FIG. 8, the solar cell 10 according to the embodiment may include a second electrode line portion 410 of the first electrode crossing the first electrode line portion 400 on the other surface opposite the light receiving surface of the semiconductor substrate. The second electrode line portion 410 may be the bus bar electrode of the first electrode 110 and may be formed in the line form crossing the finger electrode.

In other words, the second electrode line portion 410 may include at least one bus bar electrode.

In FIGS. 7 and 8, a reference numeral 510 denotes the through hole formed in the semiconductor part. Although the through hole 510 is not usually visible, the through hole 510 is shown with the reference numeral so as to indicate a relationship between the through hole 510 and the first and second electrode line portions 400 and 410. Namely, the through hole 510 is formed at a crossing (or a crossing location) of the first electrode line portion 400 and the second electrode line portion 410.

Further, because a portion of the first electrode, for example, the connection electrode, may be formed in the through hole 510 as shown in (c) and (d) of FIG. 5, the first electrode line portion 400 and the second electrode line portion 410 may be connected to each other at the crossing of the first electrode line portion 400 and the second electrode line portion 410.

A width W1 of the first electrode line portion 400 may be less than a width W2 of the second electrode line portion 410, so as to improve the efficiency of the solar cell by increasing the size of the light receiving surface of the solar cell.

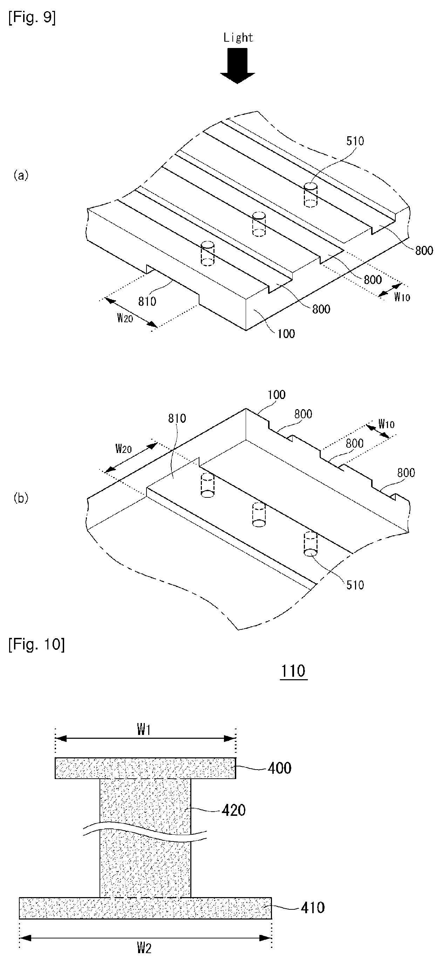

Considering the above structure of the first electrode, the semiconductor substrate 101 may have a shape shown in (a) and (b) of FIG. 9.

As shown in (a) of FIG. 9, a first region 800 where the first electrode line portion 400 (i.e., the finger electrode) is formed may be formed on the one surface of the semiconductor substrate 101. The through hole 510 may be formed in the first region 800 for the connection between the first electrode line portion 400 and the second electrode line portion 410.

A width W10 of the first region 800 may be greater than the width W1 of the first electrode line portion 400, so as to prevent a shunt phenomenon.

As shown in (b) of FIG. 9, a second region 810 where the second electrode line portion 410 (i.e., the bus bar electrode) is formed may be formed on the other surface of the semiconductor substrate 101. A width W20 of the second region 810 may be greater than the width W2 of the second electrode line portion 410, so as to prevent the shunt phenomenon. Further, the width W20 of the second region 810 may be greater than the width W10 of the first region 800.

Considering the above description, the first electrode 110, as shown in FIG. 10, may include the bus bar electrode 410, the finger electrode 400, and the connection electrode 420.

The connection electrode 420 may be the electrode for electrically connecting the first electrode line portion 400 (i.e., the finger electrode) to the second electrode line portion 410 (i.e., the bus bar electrode). It may be preferable that the connection electrode 420 overlaps the heavily doped region of the semiconductor substrate 101. The connection electrode 420 may be positioned at a crossing of the first electrode line portion 400 and the second electrode line portion 410.

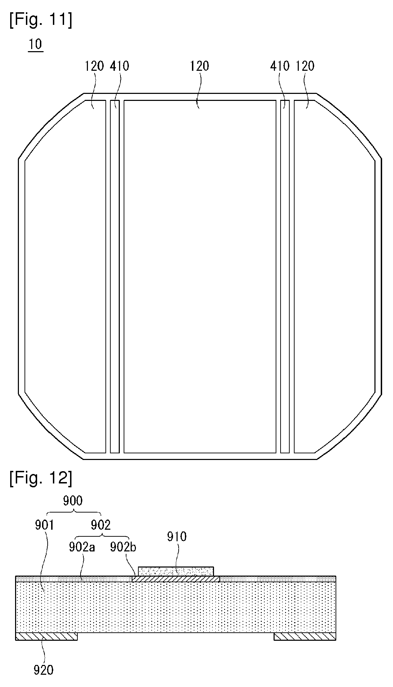

The second electrode line portion 410 is positioned on the other surface of the semiconductor substrate 101. As shown in FIG. 11, the second electrode line portion 410 is spaced apart from the second electrode 120 (i.e., the rear electrode) and thus may be electrically separated from the second electrode 120. FIG. 11 conceptually illustrates a relationship between the bus bar electrode 410 of the first electrode 110 positioned on the rear surface of the semiconductor substrate 101 and the second electrode 120. It is clearly shown that the bus bar electrode 410 and the second electrode 120 are electrically separated as a result of the edge isolation process.

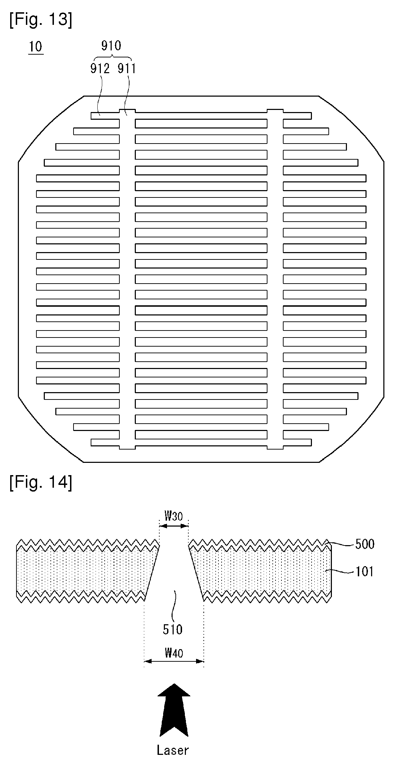

FIGS. 12 and 13 are diagrams for comparing a solar cell of a comparative example with a solar cell according to an embodiment.

As shown in FIG. 12, in a solar cell of a comparative example, a first electrode 910 is positioned on one surface (i.e., a front surface) of a semiconductor substrate 900, and a second electrode 920 is positioned on the other surface (i.e., a rear surface) of the semiconductor substrate 900.

In this case, as shown in FIG. 13, because a bus bar electrode 911 and a finger electrode 912 of the first electrode 910 are positioned on the front surface of the semiconductor substrate 900, the size of the front surface of the semiconductor substrate 900 covered by the first electrode 910 is comparatively more than when bus bar electrode is not on the front surface. Thus, the efficiency of the solar cell is reduced.

On the other hand, in the solar cell according to the embodiment illustrated in FIGS. 7 to 11, the finger electrode 400 is positioned on the front surface of the semiconductor substrate 101, and the bus bar electrode 410 is positioned on the rear surface of the semiconductor substrate 101. Thus, the size of the front surface of the semiconductor substrate 101 covered by the first electrode 110 is comparatively less than when the bus bar is on the front surface. As a result, the efficiency of the solar cell is improved.

FIG. 14 illustrates an example of another structure of the through hole.

As shown in FIG. 14, a diameter W40 of the through hole 510 measured in the other surface of the semiconductor substrate 101 may be greater than a diameter W30 of the through hole 510 measured in the one surface of the semiconductor substrate 101. Further, the through hole 510 may have a diamond shape.

For example, in a method for forming the through hole 510 using the laser, if an intensity of the laser is controlled while a laser beam is irradiated onto the semiconductor substrate 101 in the direction of the other surface of the semiconductor substrate 101, the diameter of the through hole 510 may be adjusted as shown in FIG. 14.

As above, when the width W40 of the diameter of the through hole 510 is greater than the width W30 of the diameter of the through hole 510, the efficiency of the solar cell can be improved by reducing or preventing the first electrode from covering a large part of the light receiving surface of the semiconductor substrate 101 in a state where the first electrode formed in the through hole 510 occupies a sufficiently wide size. In other words, one or both of a hole size or a first electrode size can be reduced in order to increase an area of the one surface that is able to receive the incident light.

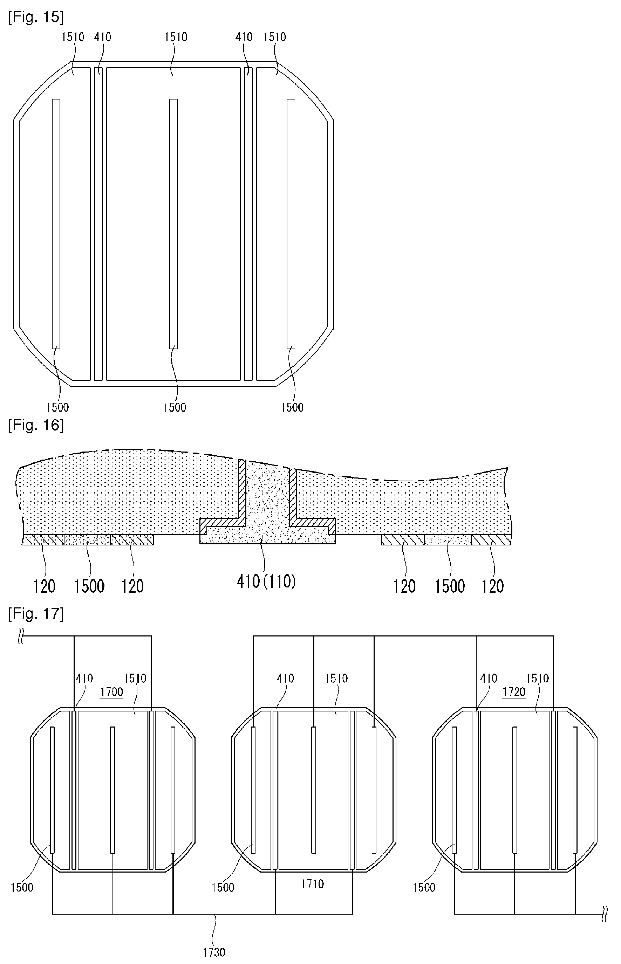

FIGS. 15 and 16 illustrate another structure of a solar cell according to an embodiment.

As shown in FIGS. 15 and 16, a rear electrode 1510, a rear bus bar electrode 1500, and a front bus bar electrode 410 of the first electrode 110 may be positioned on the rear surface of the semiconductor substrate 101. In FIGS. 15 and 16, the front bus bar electrode 410 of the first electrode 110 corresponds to the second electrode line portion of the first electrode 110 described above. In FIGS. 15 and 16, the front bus bar electrode 410 may be referred to as a first conductive bus bar electrode, and the rear bus bar electrode 1500 may be referred to as a second conductive bus bar electrode.

In other words, the second electrode 120 on the rear surface of the semiconductor substrate 101 may include the rear electrode 1510 electrically separated from the first electrode 110, and the rear bus bar electrode 1500 connected to the rear electrode 1510.

The rear bus bar electrode 1500 may be formed of a metal such as Ag. In addition, the rear bus bar electrode 1500 may be formed of a metal material different from a formation material of the rear electrode 1510 and may be formed of the same metal material as the front bus bar electrode 410.

The rear bus bar electrode 1500 may be used as a terminal for electrically connecting at least two solar cells to each other.

As above, in the solar cell according to the embodiment, both the front bus bar electrode 410 and the rear bus bar electrode 1500 may be positioned on the rear surface of the semiconductor substrate 101.

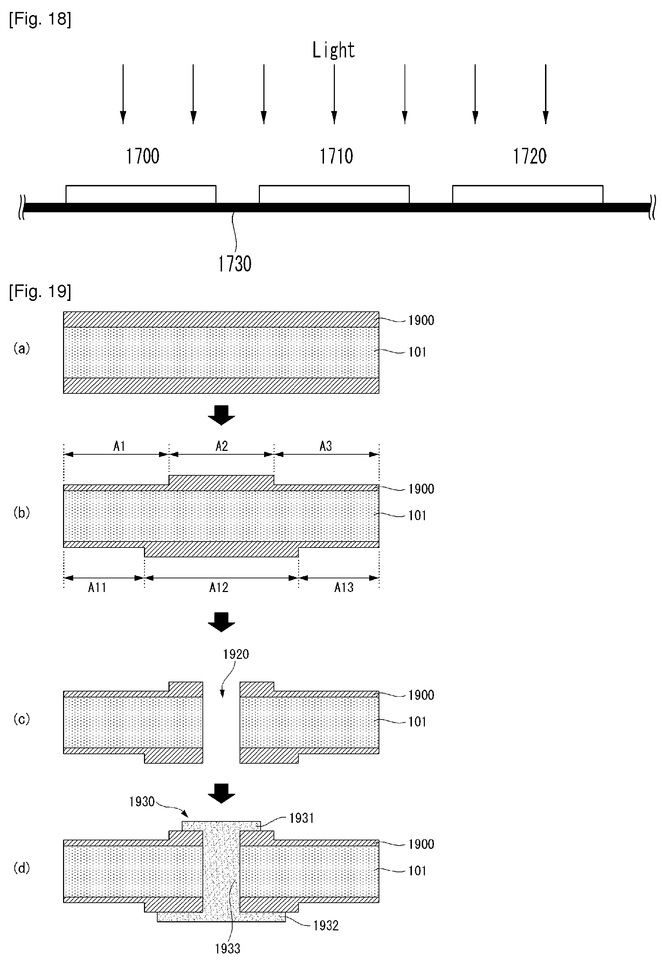

FIGS. 17 and 18 illustrate a solar cell module according to an embodiment. Solar cells described below have the same structure as the above-described solar cell. Therefore, explanations that are redundant will not be repeated unless they are necessary.

As shown in FIG. 17, in a solar cell module according to an embodiment, at least two solar cells, for example, first, second, and third solar cells 1700, 1710, and 1720 may be electrically connected to one another through a conductive ribbon 1730.

More specifically, a second conductive bus bar electrode 1500 on a rear surface of the first solar cell 1700 may be electrically connected to a first conductive bus bar electrode 410 of the second solar cell 1710 adjacent to the first solar cell 1700 through the conductive ribbon 1730. Further, a second conductive bus bar electrode 1500 of the second solar cell 1710 may be electrically connected to a first conductive bus bar electrode 410 of the third solar cell 1720 adjacent to the second solar cell 1710 through the conductive ribbon 1730.

Because both the first and second conductive bus bar electrodes 410 and 1500 of each of the first, second, and third solar cells 1700, 1710, and 1720 are positioned on a rear surface of each of the first, second, and third solar cells 1700, 1710, and 1720, the conductive ribbon 1730 for connecting the first, second, and third solar cells 1700, 1710, and 1720 to one another may be positioned on the rear surfaces of the first, second, and third solar cells 1700, 1710, and 1720 as shown in FIG. 18. Thus, less of the light receiving surfaces of the first, second, and third solar cells 1700, 1710, and 1720 may be covered by the conductive ribbon 1730 compared to a conventional solar cell. As a result, the efficiency of the solar cell may increase.

FIGS. 19 to 20 illustrate another method of manufacturing a solar cell according to an embodiment. Hereinafter, explanations that are redundant will not be repeated unless they are necessary. Descriptions about a process for forming an uneven pattern on the semiconductor substrate, a process for forming the rear electrode, and a process for forming the anti-reflection layer are omitted below.

As shown in (a) of FIG. 19, the semiconductor substrate 101 may be doped with impurities. For example, when the semiconductor substrate 101 is a p-type semiconductor, POCl₃ of n-type impurities may be diffused on the surface of the semiconductor substrate 101 to form an n-type emitter layer 1900 on the semiconductor substrate 101.

Next, as shown in (b) of FIG. 19, a portion of the emitter layer 1900 may be etched and removed. In the emitter layer 1900, an impurity doping concentration of non-etched portions A2 and A12 may be greater than an impurity doping concentration of etched portions A1, A3, A11, and A13. As an etch depth from the surface of the emitter layer 1900 increases, an impurity doping concentration of the emitter layer 1900 may be reduced. Namely, an impurity doping concentration at the surface of the emitter layer 1900 is greater than an impurity doping concentration in the inside of the emitter layer 1900.

Considering this, the impurity doping concentration of the non-etched portions A2 and A12 may be greater than the impurity doping concentration of the etched portions A1, A3, A11, and A13. Further, an amount of doped impurities in the non-etched portions A2 and A 12 may be greater than an amount of doped impurities in the etched portions A1, A3, A11, and A 13. Hence, heavily doped regions A2 and A 12 and lightly doped regions A1, A3, A11, and A13 may be formed on the semiconductor substrate 101.

In the process illustrated in (b) of FIG. 19, a width of the heavily doped region A2 on a light receiving surface (i.e., a front surface) of the semiconductor substrate 101 may be less than a width of the heavily doped region A12 on a rear surface of the semiconductor substrate 101, so that a width of a bus bar electrode 1932 to be formed in a subsequent process is greater than a width of a finger electrode 1931 to be formed in a subsequent process, but such is not required.

Although FIG. 19 illustrates the method for forming the heavily doped regions A2 and A12 and the lightly doped regions A1, A3, A11, and A13 on the front surface and the rear surface of the semiconductor substrate 101, the heavily doped region A2 and the lightly doped regions A1 and A3 may be formed only on the front surface of the semiconductor substrate 101 considering that a rear electrode (not shown) formed of A1 is formed on the rear surface of the semiconductor substrate 101.

Next, as shown in (c) of FIG. 19, a through hole 1920 may be formed in the semiconductor substrate 101.

Next, as shown in (d) of FIG. 19, a front electrode 1930 may be formed so as to contact the heavily doped regions A2 and A12. The front electrode 1930 may include the finger electrode 1931 on the front surface of the semiconductor substrate 101 and the bus bar electrode 1932 on the rear surface of the semiconductor substrate 101.

In this case, a portion of a connection electrode 1933 connecting the finger electrode 1931 to the bus bar electrode 1932 may contact the heavily doped regions A2 and A12, and another portion of the connection electrode 1933 may contact the semiconductor substrate 101. Thus, while the front electrode 1930 electrically contacts the heavily doped regions A2 and A12, the bus bar electrode 1932 of the front electrode 1930 is positioned on the rear surface of the semiconductor substrate 101.

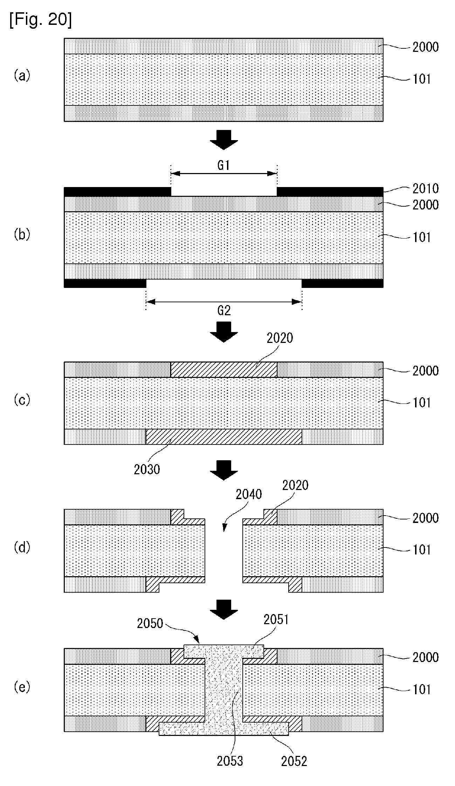

As shown in (a) of FIG. 20, the semiconductor substrate 101 may be doped with impurities to form an emitter layer 2000.

Next, as shown in (b) of FIG. 20, a diffusion barrier layer 2010 may be formed on a portion of the emitter layer 2000. The diffusion barrier layer 2010 may prevent penetration of impurities to thereby contribute to a formation of a lightly doped region.

Further, a width G1 of a non-formation portion of the diffusion barrier layer 2010 in the front surface of the semiconductor substrate 101 may be less than a width G2 of a non-formation portion of the diffusion barrier layer 2010 in the rear surface of the semiconductor substrate 101, so that a width of a bus bar electrode 2051 to be formed in a subsequent process is greater than a width of a finger electrode 2052 to be formed in a subsequent process, but such is not required.

Next, as shown in (c) of FIG. 20, the semiconductor substrate 101 may be again doped with impurities in a state where the diffusion barrier layer 2010 is formed. A conductive type of the impurities in the process illustrated in (c) of FIG. 20 may be substantially the same as a conductive type of the impurities in the process illustrated in (a) of FIG. 20. For example, n-type impurities may be used in the above (a) and (c) processes.

As a result, because an amount of doped impurities in a formation (or covered) portion of the semiconductor substrate 101 having the diffusion barrier layer 2010 may be relatively less than an amount of doped impurities in another (or non-covered) portion of the semiconductor substrate 101, a lightly doped region may be formed on the semiconductor substrate 101. Further, because an amount of doped impurities in the non-formation (or non-covered) portion of the semiconductor substrate 101 having the diffusion barrier layer 2010 may be relatively more than an amount of doped impurities in another (or covered) portion of the semiconductor substrate 101, a heavily doped region may be formed on the semiconductor substrate 101.

Afterwards, the diffusion barrier layer 2010 may be removed to form a through hole 2040 in the semiconductor substrate 101 as shown in (d) of FIG. 20.

Next, as shown in (d) of FIG. 20, a front electrode 2050 may be formed so as to contact the heavily doped region. Further, the front electrode 2050 may include a finger electrode 2051 on the front surface of the semiconductor substrate 101 and a bus bar electrode 2052 on the rear surface of the semiconductor substrate 101.

In this case, in the same manner as the structure illustrated in FIG. 19, a portion of a connection electrode 2053 connecting the finger electrode 2051 to the bus bar electrode 2052 may contact the heavily doped region, and another portion of the connection electrode 2053 may contact the semiconductor substrate 101.

## Claims

1. A solar cell (10) comprising:
a semiconductor substrate (101) doped with first impurities;
an emitter layer (102) on a first surface of the semiconductor substrate (101), the emitter layer (102) including a first portion (102a) doped with second impurities, whose conductive type is different from the first impurities, at a first doping concentration and a second portion (102b) doped with the second impurities at a second doping concentration greater than the first doping concentration;
a first electrode (110) that passes through the semiconductor substrate (101) to extend from the first surface of the semiconductor substrate (101) to a second surface of the semiconductor substrate (101) and contacts the second portion (102b) of the emitter layer (102); and
a second electrode (120) that is positioned on the second surface of the semiconductor substrate (101) and is electrically separated from the first electrode (110),
**characterized in that** a doping depth of the second impurities in the second portion (102b) is greater than a doping depth of the second impurities in the first portion (102a).

2. The solar cell of claim 1, wherein the first electrode includes:
a first electrode line portion (400) on the first surface of the semiconductor substrate (101) and;
a second electrode line portion (410) on the second surface of the semiconductor substrate (101), the second electrode line portion (410) crossing the first electrode line portion (400).

3. The solar cell of claim 2, wherein the first electrode line portion (400) is connected to the second electrode line portion (410) through at least one through hole in the semiconductor substrate (101).

4. The solar cell of claim 1, wherein a surface doping concentration of the second portion (102b) is greater than a surface doping concentration of the first portion (102a).

5. The solar cell of claim 2, further comprising an anti-reflection layer (130) on the first surface of the semiconductor substrate (101).

6. The solar cell of claim 5, wherein the first electrode line portion passes through the anti-reflection layer (130) to be connected to the second portion of the emitter layer (102).

7. The solar cell of claim 1, wherein the first surface of the semiconductor substrate (101) is a light receiving surface.

8. The solar cell of claim 3, wherein the second portion (102b) of the emitter layer (130) includes a portion positioned inside the at least one through hole.

9. A method of manufacturing a solar cell comprising:
forming a through hole (510) on a semiconductor substrate (101);
forming an emitter layer (102) by doping the semiconductor substrate with first conductive type impurities different from a conductive type of the semiconductor substrate at a first doping concentration to form a first portion (102a) and doping the semiconductor substrate with the first conductive type impurities at a second doping concentration greater than the first doping concentration to form a second portion (102b);
forming a front electrode (400) in a first region (800) on a front surface of the semiconductor substrate (101);
forming a front bus bar electrode (410) on a second region (810) on a rear surface of the semiconductor substrate (101) to connect the front bus bar electrode (410) to the front electrode (400) through the through hole (510); and
forming a rear electrode (120) on the rear surface of the semiconductor substrate (101),
**characterized by** forming the emitter layer (102) such that a doping depth of the second impurities in the second portion (102b) is greater than a doping depth of the second impurities in the first portion (102a).

10. The method of claim 9, further comprising, before forming the emitter layer, forming a diffusion barrier layer (500) in a portion where the first region (800) is to be formed.

## Patentansprüche

1. Solarzelle (10) umfassend:
ein Halbleitersubstrat (101), welches mit ersten Störstellen dotiert ist,
eine Emitterschicht (102) auf einer ersten Oberfläche des Halbleitersubstrats (101),
wobei die Emitterschicht (102) einen ersten Abschnitt (102a), welcher mit zweiten Störstellen eines von den ersten Störstellen verschiedenen Leitungstyps mit einer ersten Dotierungskonzentration dotiert ist, sowie einen zweiten Abschnitt (102b) aufweist, welcher mit den zweiten Störstellen mit einer zweiten
Dotierungskonzentration dotiert ist, die größer als die erste Dotierungskonzentration ist,
eine erste Elektrode (110), welche durch das Halbleitersubstrat (101) verläuft, um sich von der ersten Oberfläche des Halbleitersubstrats (101) zu einer zweiten Oberfläche des Halbleitersubstrats (101) zu erstrecken, und welche den zweiten Abschnitt (102b) der Emitterschicht (102) kontaktiert, und
eine zweite Elektrode (120), welche auf der zweiten Oberfläche des Halbleitersubstrats (101) angeordnet ist und elektrisch von der ersten Elektrode (110) separiert ist,
**dadurch gekennzeichnet, dass** eine Dotierungstiefe der zweiten Störstellen in dem zweiten Abschnitt (102b) größer als eine Dotierungstiefe der zweiten Störstellen in dem ersten Abschnitt (102a) ist.

2. Solarzelle nach Anspruch 1, wobei die erste Elektrode umfasst:
einen ersten Elektrodenbahnabschnitt (400) auf der ersten Oberfläche des Halbleitersubstrats (101), und
einen zweiten Elektrodenbahnabschnitt (410) auf der zweiten Oberfläche des Halbleitersubstrats (101), wobei der zweite Elektrodenbahnabschnitt (410) den ersten Elektrodenbahnabschnitt (400) kreuzt.

3. Solarzelle nach Anspruch 2, wobei der erste Elektrodenbahnabschnitt (400) mit dem zweiten Elektrodenbahnabschnitt (410) über mindestens ein Durchgangsloch in dem Halbleitersubstrat (101) verbunden ist.

4. Solarzelle nach Anspruch 1, wobei eine Oberflächendotierungskonzentration des zweiten Abschnitts (102b) größer als eine Oberflächendotierungskonzentration des ersten Abschnitts (102a) ist.

5. Solarzelle nach Anspruch 2, ferner umfassend eine Antireflexionsschicht (130) auf der ersten Oberfläche des Halbleitersubstrats (101).

6. Solarzelle nach Anspruch 5, wobei der erste Elektrodenbahnabschnitt durch die Antireflexionsschicht (130) verläuft, um mit dem zweiten Abschnitt der Emitterschicht (102) verbunden zu sein.

7. Solarzelle nach Anspruch 1, wobei die erste Oberfläche des Halbleitersubstrats (101) eine Lichtempfangsfläche ist.

8. Solarzelle nach Anspruch 3, wobei der zweite Abschnitt (102b) der Emitterschicht (130) einen innerhalb des mindestens einen Durchgangslochs angeordneten Abschnitt umfasst.

9. Verfahren zur Herstellung einer Solarzelle, umfassend:
Bilden eines Durchgangslochs (510) auf einem Halbleitersubstrat (101),
Bilden einer Emitterschicht (102) durch Dotieren des Halbleitersubstrats mit Störstellen eines ersten Leitungstyps, der sich von einem Leitungstyp des Halbleitersubstrats unterscheidet, mit einer ersten Dotierungskonzentration, um einen ersten Abschnitt (102a) zu bilden, und durch Dotieren des Halbleitersubstrats mit den Störstellen des ersten Leitfähigkeitstyps mit einer zweiten Dotierungskonzentration, die größer als die erste Dotierungskonzentration ist, um einen zweiten Abschnitt (102b) zu bilden,
Bilden einer Vorderelektrode (400) in einem ersten Bereich (800) auf einer Vorderfläche des Halbleitersubstrats (101),
Bilden einer vorderen Busstrangelektrode (410) auf einem zweiten Bereich (810) auf einer Rückfläche des Halbleitersubstrats (101), um die vordere Busstrangelektrode (410) durch das Durchgangsloch (510) mit der Vorderelektrode (400) zu verbinden, und
Bilden einer rückseitigen Elektrode (120) auf der Rückfläche des Halbleitersubstrats (101),
**gekennzeichnet durch** Bilden der Emitterschicht (102) derart, dass eine Dotierungstiefe der zweiten Störstellen in dem zweiten Abschnitt (102b) größer als eine Dotierungstiefe der zweiten Störstellen in dem ersten Abschnitt (102a) ist.

10. Verfahren nach Anspruch 9, ferner umfassend: Bilden einer Diffusionsgrenzschicht (500) in einem Abschnitt, wo der erste Bereich (800) zu bilden ist, vor dem Bilden der Emitterschicht.

## Revendications

1. Cellule solaire (10), comprenant :
un substrat semi-conducteur (101) dopé avec des premières impuretés ;
une couche d'émetteur (102) sur une première surface du substrat semi-conducteur (101), la couche d'émetteur (102) comprenant une première partie (102a) dopée avec des deuxièmes impuretés, dont le type de conductivité est différent de celui des premières impuretés, à une première concentration en dopant et une deuxième partie (102b) dopée avec les deuxièmes impuretés à une deuxième concentration en dopant supérieure à la première concentration en dopant ;
une première électrode (110) qui passe à travers le substrat semi-conducteur (101) pour s'étendre de la première surface du substrat semi-conducteur (101) à une deuxième surface du substrat semi-conducteur (101) et être au contact de la deuxième partie (102b) de la couche d'émetteur (102) ; et
une deuxième électrode (120) qui est positionnée sur la deuxième surface du substrat semi-conducteur (101) et est séparée électriquement de la première électrode (110),
**caractérisée en ce qu'**une profondeur de dopage des deuxièmes impuretés dans la deuxième partie (102b) est supérieure à une profondeur de dopage des deuxièmes impuretés dans la première partie (102a).

2. Cellule solaire selon la revendication 1, dans laquelle la première électrode comprend :
une première partie de ligne d'électrodes (400) sur la première surface du substrat semi-conducteur (101) et ;
une deuxième partie de ligne d'électrodes (410) sur la deuxième surface du substrat semi-conducteur (101), la deuxième partie de ligne d'électrodes (410) croisant la première partie de ligne d'électrodes (400).

3. Cellule solaire selon la revendication 2, dans laquelle la première partie de ligne d'électrodes (400) est reliée à la deuxième partie de ligne d'électrodes (410) par au moins un trou traversant dans le substrat semi-conducteur (101).

4. Cellule solaire selon la revendication 1, dans laquelle une concentration de la surface en dopant de la deuxième partie (102b) est supérieure à une concentration de la surface en dopant de la première partie (102a).

5. Cellule solaire selon la revendication 2, comprenant en outre une couche antireflet (130) sur la première surface du substrat semi-conducteur (101).

6. Cellule solaire selon la revendication 5, dans laquelle la première partie de ligne d'électrodes passe à travers la couche antireflet (130) pour être reliée à la deuxième partie de la couche d'émetteur (102).

7. Cellule solaire selon la revendication 1, dans laquelle la première surface du substrat semi-conducteur (101) est une surface de réception de lumière.

8. Cellule solaire selon la revendication 3, dans laquelle la deuxième partie (102b) de la couche d'émetteur (130) comprend une partie disposée à l'intérieur du au moins un trou traversant.

9. Procédé de fabrication d'une cellule solaire, comprenant :
la formation d'un trou traversant (510) sur un substrat semi-conducteur (101) ;
la formation d'une couche d'émetteur (102) par dopage du substrat semi-conducteur avec des premières impuretés d'un type de conductivité différentes d'un type de conductivité du substrat semi-conducteur à une première concentration en dopant pour former une première partie (102a) et le dopage du substrat semi-conducteur avec les premières impuretés d'un type de conductivité à une deuxième concentration en dopant supérieure à la première concentration en dopant pour former une deuxième partie (102b) ;
la formation d'une électrode avant (400) dans une première région (800) sur une surface avant du substrat semi-conducteur (101) ;
la formation d'une électrode de barre omnibus avant (410) sur une deuxième région (810) sur une surface arrière du substrat semi-conducteur (101) pour relier l'électrode de barre omnibus avant (410) à l'électrode avant (400) par l'intermédiaire du trou traversant (510 ) ; et
la formation d'une électrode arrière (120) sur la surface arrière du substrat semi-conducteur (101),
**caractérisé par** la formation de la couche d'émetteur (102) de telle sorte qu'une profondeur de dopage des deuxièmes impuretés dans la deuxième partie (102b) est supérieure à une profondeur de dopage des deuxièmes impuretés dans la première partie (102a).

10. Procédé selon la revendication 9, comprenant en outre, avant la formation de la couche d'émetteur, la formation d'une couche barrière à la diffusion (500) dans une partie où la première région (800) doit être formée.
